# EUROPÄISCHE PATENTSCHRIFT

(11) **EP 0 956 601 B1**
(45) Veröffentlichungstag und Bekanntmachung des Hinweises auf die Patenterteilung: **19.03.2003**
(21) Anmeldenummer: 98907874.6
(22) Anmeldetag: 29.01.1998
(51) Int. Cl.: H01L 33/00, H01S 5/32

(54) **OPTOELEKTRONISCHES HALBLEITERBAUELEMENT**
OPTOELECTRONIC SEMICONDUCTOR COMPONENT
COMPOSANT A SEMICONDUCTEUR OPTOELECTRONIQUE

(30) Priorität: 31.01.1997 DE 19703615
(43) Veröffentlichungstag der Anmeldung: 17.11.1999
(73) Patentinhaber: Infineon Technologies AG, 81669 München (DE)
(72) Erfinder: LANDWEHR, Gottfried, D-97074 Würzburg (DE); KEIM, Markus, D-97072 Würzburg (DE); REUSCHER, Günter, D-97074 Würzburg (DE); LITZ, Thomas, D-97074 Würzburg (DE); BARON, Thierry, D-97218 Gerbrunn (DE); FISCHER, Frank, D-97074 Würzburg (DE); LUGAUER, Hans-Jürgen, D-97218 Gerbrunn (DE)
(74) Vertreter: Maikowski, Michael, Dipl.-Ing. Dr.
(86) Internationale Anmeldenummer: DE9800263
(87) Internationale Veröffentlichungsnummer: WO98034284

(56) Entgegenhaltungen:
- EP-A- 0 709 939
- US-A- 5 338 944
- AKIRA ISHIBASHI: "II-VI BLUE-GREEN LASER DIODES" IEEE JOURNAL OF SELECTED TOPICS IN QUANTUM ELECTRONICS, Bd. 1, Nr. 2, 1.Juni 1995, Seiten 741-748, XP000521133 in der Anmeldung erwähnt

## Beschreibung

Die Erfindung bezieht sich auf ein optoelektronisches Halbleiterbauelement mit einem zur Erzeugung einer elektromagnetischen Strahlung geeigneten Halbleiterkörper, bei dem über einem Halbleitersubstrat, das insbesondere n-leitend ist, eine aktive Schichtenfolge angeordnet ist, innerhalb der bei Stromfluss durch den Halbleiterkörper die elektromagnetische Strahlung erzeugt wird und der mindestens eine schlecht dotierbare Halbleiterschicht eines ersten Leitungstyps, insbesondere eine p-dotierte ZnSe aufweisende II-VI-Halbleiterschicht, eine p-dotierte GaN aufweisende III-V-Halbleiterschicht oder eine n-dotierte CdTe aufweisende II-VI-Halbleiterschicht, zugeordnet ist.

Ein derartiges optoelektroniches Halbleiterbauelemennt ist beispielsweise aus der US-Patentschrift 5,268,918 bekannt. Hierin ist ein Halbleiterkörper eines Halbleiterlaser-Bauelements beschrieben, bei dem auf einem Halbleitersubstrat, bestehend aus n- oder p-leitendem GaAs oder GaP, eine n-bzw. p-leitende erste Mantelschicht, bestehend aus ZnMgSSe oder BeZnSTe, aufgebracht ist, auf der wiederum eine aktive Schicht, bestehend aus ZnSSe oder ZnCdSe angeordnet ist. Auf der aktiven Schicht befindet sich eine p- bzw. n-leitende zweite Mantelschicht, bestehend aus ZnMgSSe oder BeZnSTe. Dieses optoelektronische Bauelement gemäß US 5,268,918 beruht auf dem Prinzip der sogenannten "Separate Confinement Heterostructure"(SCH). Bei dieser Schichtstruktur werden die elektrischen Ladungsträger und die erzeugten Lichtwellen voneinander unabhängig geführt. Elektronen und Löcher werden in die lichtemittierende aktive Zone injiziert, die als Einfachoder Mehrfach-Quantentopfstruktur (Single Quantum Well,SQW bzw. Multiple Quantum Well,MQW) ausgebildet ist und somit eine geringere Bandlücke besitzt, als an die aktive Zone angrenzende Barriereschichten. Die Barriereschichten (Wellenleiterschichten) besitzen einen kleineren Brechungsindex als die aktive Zone und gleichzeitig einen größeren Brechungsindex als die an die Barriereschichten angrenzenden Mantelschichten. Durch diesen Brechzahlunterschied wird die generierte Lichtwelle auf den engen Bereich um die aktive Zone beschränkt. Durch entgegengesetzte Dotierung der beiden Mantelschichten entsteht ein pn-Übergang, in welchen durch Anlegen einer geeigneten Spannung Ladungsträger injiziert werden.

Ähnliche optoelektronische Halbleiterbauelemente sind beispielsweise in A. Ishibashi, "II-VI Blue-Green Laser Diodes", IEEE Journal of Selected Topics in Quantum Electronics, 1, 741 bis 748 (1995) und in JP 07-066494 beschrieben.

Die prinzipiellen Strukturen von SQW- und MQW-Halbleiterlasern und des SCH-Aufbaus sind beispielsweise in W. Buldau, Halbleiter-Optoelektronik, Hanser Verlag, München, Wien, 1995, S. 182 - 187, beschrieben und werden von daher an dieser Stelle nicht mehr näher erläutert.

In der Halbleitertechnik tritt häufig das Problem auf, daß bestimmte Halbleitermaterialien schlecht p- oder n-dotierbar sind. Insbesondere sind diesbezüglich II-IV-Halbleitermaterialien, die ZnSe, (schlecht p-dotierbar; insbesondere ZnMgSSe oder BeMgZnSe) oder CdTe (schlecht n-dotierbar), oder III-V-Halbleitermaterialen, die GaN (schlecht p-dotierbar) aufweisen. In der US 5,338,944 ist beispielsweise eine blaues Licht emittierende SiC-Diode beschrieben, bei der das Problem einer schlechten Transparenz von p-dotiertem SiC mittels eines entarteten pn-Überganges auf einer dünnen p-dotierten SiC-Schicht gelöst wird.

Besonders bei SQW- und MQW-Halbleiterlasern mit SCH-Aufbau auf der Basis von II-VI-Halbleitermaterial, bei denen eine p-leitende Deckschicht (Wellenleiterschicht oder Mantelschicht) aus auf ZnSe basierendem Halbleitermaterial, insbesondere ZnMgSSe oder BeMgZnSe eingesetzt ist, beeinträchtigt dieses Problem die Funktionseigenschaften des Lasers in hohem Maße.

Durch die Variation der Mg- und der S- bzw. der Be- und Mg-Konzentration kann die Bandlücke und auch der Brechungsindex der oben genannten Materialien eingestellt werden. Mit zunehmenden Anteilen von Magnesium und Schwefel bzw. Beryllium und Magnesium sinkt aber die Effizienz des in den oben genannten Zusammensetzungen als Akzeptor zur p-Leitung verwendeten plasmaaktivierten Stickstoffes. Damit haben Schichten mit höheren Mg- und S-Konzentrationen bzw. höheren Beund Mg-Konzentrationen immer einen großen elektrischen Widerstand. Zudem erhöhen sich damit die Widerstände der elektrischen Kontakte an diese Schichten, wodurch die Eigenschaften des Laserbauelements weiter verschlechtert werden. Diese Probleme führen in herkömmlichen II-VI-Halbleiterlasern dazu, dass nur Deckschichten mit einer maximalen Bandlücke von ca. 2,95 eV (300 K) eingesetzt werden.

Durch diese Beschränkung ist die Höhe der Energiebarriere zwischen dem Halbleitermaterial der Quantentopfstruktur (SQW oder MQW) und den Mantelschichten deutlich begrenzt, wodurch elektrische Ladungsträger ungenügend im Quantentopf eingeschlossen werden.

Gerade um Emissionswellenlängen von kleiner als ca. 500 nm zu erzielen, ist es jedoch wichtig, höhere Barrieren zu schaffen, was bisher in den ZnMgSSe-SCH-Halbleiterlasern nur schwer erreicht wird. Des Weiteren ist bei geringen Mg- und S-Konzentrationen in den Mantelschichten der Brechungsindexsprung zwischen den Wellenleiterschichten und den Mantelschichten relativ klein, so dass eine in der aktiven Zone erzeugte Lichtwelle nur schwach geführt ist.

Ein weiteres Problem bei bekannten II-VI-Halbleiterlasern ist die Ausbildung eines ohmschen Kontaktes zu p-leitenden: Schichten. Zur Verbesserung dieses ohmschen Kontaktes auf der p-leitenden Seite des Halbleiterlasers wird bislang in der Regel ein Übergitter aus ZnSe und ZnTe verwendet, bei welchem die strukturelle Qualität aufgrund der hohen Gitterfehlpassung zwischen ZnSe und ZnTe sehr schlecht ist. Daneben wurden auch BeZnTeSe-Grading oder BeTe/ZnSe-Pseudograding als p-Kontakt vorgeschlagen. Bei diesen Kontaktschichten ist es technologisch schwierig, eine Oxidation des hygroskopischen Materials BeTe an der Halbleiteroberfläche zu unterbinden. Bei der Verwendung eines BeZnTeSe-Gradings oder eines BeTe/ZnSe-Pseudogradings als elektrisch aktive Pufferschicht zwischen der p-leitenden Mantelschicht und dem Halbleitersubstrat wird p-leitendes GaAs als Halbleitersubstrat verwendet, da die Valenzbanddiskontinuität zwischen BeTe und GaAs klein ist. Nachteilig hierbei ist, dass p-leitendes GaAs kommerziell nur in geringerer Qualität als n-leitendes GaAs erhältlich ist, wodurch die strukturellen Eigenschaften der aufgebrachten Epitaxieschichten deutlich schlechter werden.

Die Aufgabe der vorliegenden Erfindung besteht darin, ein optoelektronisches Bauelement der eingangs genannten Art zu entwickeln, das im Vergleich zu dem oben beschriebenen bekannten optoelektronischen Halbleiterbauelement eine verbesserte Funktionsfähigkeit aufweist. Es soll insbesondere ein verbessertes Halbleiterlaserbauelement für den Spektralbereich zwischen 680 nm und 300 nm zur Verfügung gestellt werden.

Diese Aufgabe wird durch ein optoelektronisches Bauelement mit den Merkmalen des Anspruches 1 gelöst. Weitere vorteilhafte Ausgestaltungen ergeben sich aus den diesem nachgeordneten abhängigen Ansprüchen.

Erfindungsgemäß ist vorgesehen, dass zwischen der schlecht dotierbaren Halbleiterschicht des ersten Leitungstyps (p-oder n-dotiert) und einer dieser zugeordneten Kontaktschicht (z. B. Kontaktmetallisierung) des Halbleiterkörpers eine erste hochdotierte entartete Übergangsschicht des ersten Leitungstyp (p⁺- oder n⁺-dotiert) und eine zweite hochdotierte entartete Übergangsschicht eines dem ersten Leitungstyps entgegengesetzten zweiten Leitungstyps (n⁺- bzw. p⁺-dotiert) angeordnet sind, derart, dass sich die erste hochdotierte entartete Übergangsschicht zwischen der schlecht dotierbaren Halbleiterschicht und der zweiten hochdotierten entarteten Übergangsschicht befindet.

Bevorzugt wird die erfindungsgemäße Lösung bei auf ZnSe basierenden Halbleiterlaserbauelementen mit Quantentopfstruktur (SQW oder MQW), insbesondere mit SCH-Aufbau, eingesetzt. Hierbei ist die aktive Zone zwischen einer ersten Wellenleiterschicht und einer zweiten Wellenleiterschicht angeordnet, die entsprechend dem SCH-Aufbau wiederum zwischen einer ersten und einer zweiten äußeren Mantelschicht eingeschlossen ist. Bevorzugt ist hierbei die erste äußere Mantelschicht n-dotiert, weist die zweite äußere Mantelschicht die schlecht dotierbare Halbleiterschicht, eine p-dotierte ZnSe aufweisende II-VI-Halbleiterschicht, auf und sind die erste hochdotierte entartete Übergangsschicht, eine p⁺-leitende Übergangsschicht, und die zweite hochdotierte entartete Übergangsschicht, eine n⁺-leitende Übergangschicht, zwischen der zweiten äußeren Mantelschicht und der dieser zugeordneten Kontaktschicht des Halbleiterkörpers angeordnet.

Diese p⁺n⁺-Schichtenfolge dient beispielsweise als elektrischer Kontakt zwischen einer p-leitenden Mantelschicht und einem n-leitenden Halbleitersubstrat oder zwischen einer p-leitenden Mantelschicht und einer Kontaktschicht des Halbleiterkörpers. Durch die relativ zum Bauteil rückwärtsgepolte p⁺n⁺-Schichtenfolge werden Ladungsträger innerhalb eines elektrischen Feldes in der p⁺n⁺-Schichtenfolge beschleunigt und rasch in die aktive Zone injiziert. In der p⁺n⁺-Schichtenfolge kommt es in der Distanz einer Debye-Länge um den Übergang herum zu einer echten Umkehr des Leitungstypes, d.h. das Fermi-Niveau wird durch n-Dotierung auf einer Seite der Diode ins Leitungsband gebracht und auf der gegenüberliegenden Seite ziehen Löcher durch p-Dotierung das Fermi-Niveau ins Valenzband ("Entartung"). Durch die sehr schmale Raumladungszone von wenigen Angström zwischen diesen entartet dotierten Gebieten der p⁺n⁺-Diode kann es unter Rückwärtspolung zu Interbandtunneln von Elektronen aus dem Valenzband des p-dotierten Halbleiters in Zustände des Leitungsbandes des n-dotierten Halbleiters kommen, wodurch im p-dotierten Gebiet Löcher entstehen.

Bei einer weiteren bevorzugten Ausführungsform eines erfindungsgemäßen Quantentopf-SCH-Halbleiterlasers sind die erste äußere Mantelschicht und die zweite äußere Mantelschicht n-dotiert und sind zwischen einer der beiden Wellenleiterschichten und der dieser von der aktiven Zone aus gesehen nachgeordneten Mantelschicht die schlecht dotierbare Halbleiterschicht, z. B. eine p-dotierte ZnSe aufweisende II-VI-Halbleiterschicht, die erste hochdotierte entartete Übergangsschicht, z. B. eine p⁺-leitende Übergangsschicht, und die zweite hochdotierte entartete Übergangsschicht, z. B. eine n⁺-leitende Übergangs schicht angeordnet. Hierbei wirkt die p⁺n⁺-Schichtenfolge als "Löcherkonverter" oder "Injektor" nahe der aktiven Schichtenfolge.

Bei den erfindungsgemäßen Bauelementen, insbesondere bei der letztgenannten Ausführungsform, werden Elektronen zum Ladungstransport verwendet, die erst kurz vor der aktiven Zone in Löcher umgewandelt werden. Dieser Bereich kann gut mit BeTe, insbesondere mit BeMgZnTe oder BeZnCdTe erzeugt werden, da BeTe auf einfache Weise hoch p-leitend dotierbar und gut gitterangepasst ist.
Eine besonders bevorzugte Weiterbildung des erfindungsgemäßen optoelektronischen Bauelements ist ein SCH-Quantentopf-Laser, bei dem die aktive Zone, die Deckschichten (Wellenleiterschichten und äußere Mantelschichten) und die Übergangsschichten Halbleitermaterialien aus der Gruppe der berylliumhaltigen Chalkogenide aufweisen. Besonders bevorzugte Materialien sind beispielsweise für die aktive Zone BeₓZn_{y}Cd_{1-x-y}Se (0 ≤ x ≤ 1, x+y ≤ 1), für die Deckschichten BeₓMg_{y}Zn_{1-x-y}Se (0 ≤ x ≤ 1, 0 ≤ y ≤ 1, x+y ≤ 1) oder Zn₁₋ ₓMgₓS_{y}Se_{1-y} (0 ≤ x ≤ 1, 0 ≤ y ≤ 1), für die p⁺-leitende Übergangsschicht hochdotiertes, p-leitendes BeₓMg_{y}Zn_{1-x-y}Te (0 ≤ x ≤ 1, x+y ≤ 1) und für die n⁺-leitende Übergangsschicht hochdotiertes, n-leitendes InₓGa₁₋ₓAs oder hochdotiertes, n-leitendes BeₓMg_{y}Zn_{1-x-y}Se (0 ≤ x ≤ 1,
0 ≤ y ≤ 1, x+y ≤ 1). Zwischen der p⁺-leitenden Übergangsschicht und der dieser am nächsten liegenden Wellenleiterschicht ist vorzugsweise eine Anpassungsschicht angeordnet, die ein BeZnTeSe-Grading oder ein BeTe/ZnSe-Pseudograding aufweist. Bevorzugt ist bei dieser Weiterbildung ein bekanntermaßen auf einfache Weise in guter Qualität verfügbares n-leitendes GaAs-Halbleitersubstrat und ein besonders einfach herstellbarer herkömmlicher n-Vorderseitenkontakt verwendet.

Ein Grading ist eine Schichtstruktur, bei welcher die Anteile der Konstituenten, in diesem Beispiel der Be- und Te-Konzentration, in einer Raumrichtung variiert werden, um eine allmähliche Anpassung, zum Beispiel der Leitungsbandenergie zu. erhalten. Bei einem Pseudograding wird diese Variation durch ein sich änderndes Schichtdickenverhältnis von abwechselnd aufeinanderfolgenden, dünnen Schichten unterschiedlicher Zusammensetzung erreicht. Dabei müssen die Schichtdicken so dünn gewählt werden, dass ein effizienter Ladungsträgertransport gewährleistet wird.

Eine andere besonders bevorzugte Weiterbildung des erfindungsgemäßen optoelektronischen Bauelements ist ebenfalls ein SCH-Quantentopf-Laser, bei dem die aktive Zone, die Deckschichten (Wellenleiterschichten und äußere Mantelschichten) und die Übergangs schichten Halbleitermaterialien aus der Gruppe der berylliumhaitigen Chalkogenide aufweisen. Als besonders bevorzugte Materialien für die einzelnen Schichten sind die im Zusammenhang mit dem zuletzt beschriebenen erfindungsgemäßen SCH-Quantentopf-Laser anzuführen. Im Unterschied zur oben genannten Struktur sind jedoch hier die p⁺-leitenden Übergangsschicht und die n⁺-leitende Übergangsschicht zwischen einer Wellenleiterschicht und einer Mantelschicht angeordnet und weisen die erste und die zweite Mantelschicht denselben Leitungstyp auf. Zusätzlich kann sich vorteilhafterweise zwischen der p⁺-leitenden Übergangsschicht und der oben genannten Wellenleiterschicht eine Anpassungsschicht, beispielsweise in Form eines BeZnTeSe-Gradings oder eines BeTe/ZnSe-Pseudogradings, befinden. Diese zusätzliche Anpassungsschicht ermöglicht einen Transport von Ladungsträgern in den Quantentopf. Sie bildet für Ladungsträger eines ersten Typs eine Barriere und ermöglicht gleichzeitig einen Durchtritt für den komplementären Ladungsträgertyp. Bevorzugt ist auch bei dieser Weiterbildung ein bekanntermaßen auf einfache Weise in guter Qualität verfügbares n-leitendes GaAs-Halbleitersubstrat und ein besonders einfach herstellbarer herkömmlicher n-Vorderseitenkontakt verwendbar.

Vorteilhafterweise beträgt bei den oben beschriebenen bevorzugten Weiterbildungen der Abstand zwischen den beiden Mantelschichten zwischen ca. 100 nm und ca. 400 nm und weisen die beiden Mantelschichten jeweils eine Schichtdicke von mindestens 200 nm auf.

Mit dem erfindungsgemäßen Aufbau können hohe Konzentrationen von Be und Mg in BeMgZnSe bzw. auch Mg und S in ZnMgSSe in den Mantelschichten erzielt werden, da die n-Dotierung dieser Materialien erfahrungsgemäß effizienter als die p-Dotierung ist. Auf diese Weise können Bandlücken in den Mantelschichten von über 3,1 eV (300K) erreicht werden. Mit diesen hohen Konzentrationen ist es möglich, den elektrischen Ladungsträgereinschluss zu verbessern und die optische Welle besser zu führen. Darüber hinaus entfallen hochohmige Bereiche, die durch p-dotiertes BeMgZnSe oder ZnMgSSe eingebracht werden.

Ein weiterer Vorteil ergibt sich bei der Verwendung von BeₓMg_{y}Zn_{1-x-y}Te in Bauelementen, die kurzwelliges Licht mit Wellenlängen kleiner als 460nm emittieren. Für diese Wellenlänge hat BeₓMg_{y}Zn_{1-x-y}Te einen kleineren Brechungsindex als zum Beispiel BeₓZn_{y}Cd_{1-x-y}Se, wodurch die optische Welle unter Verwendung von BeₓMg_{y}Zn_{1-x-y}Te in der p⁺-leitenden Übergangsschicht und in der Anpassungsschicht noch besser geführt wird.

Als p-Dotierstoffe für BeTe und somit auch für BeMgZnTe und BeZnCdTe kann neben plasmaaktiviertem Stickstoff vorteilhafterweise As eingesetzt sein. As weist gegenüber Stickstoff eine deutlich geringere Diffusion auf, was zu einer erhöhten Stabilität der Dotierung führt. Ebenso können auch ein oder mehrere Dotierstoffe aus der Gruppe Sb, P, Gruppe-I-Elemente wie K, Rb und Cs und Gruppe-IV-Elemente wie C, Si, Ge und Sn als Dotierstoff eingesetzt sein.

Das erfindungsgemäße optoelektronische Halbleiterbauelement wird im Folgenden anhand von vier Ausführungsbeispielen in Verbindung mit den Figuren 1 bis 5 näher erläutert. Es zeigen:
Figur 1 eine schematische Darstellung einer Schichtstruktur eines ersten Ausführungsbeispiels,
Figur 2 eine schematische Darstellung einer Schichtstruktur eines zweiten Ausführungsbeispiels,
Figur 3 eine schematische Darstellung einer Schichtstuktur eines dritten Ausführungsbeispieles,
Figur 4 eine schematische Darstellung einer Schichtstruktur eines vierten Ausführungsbeispieles und
Figur 5 ein Energiebandschema für das Ausführungsbeispiel von Figur 3.

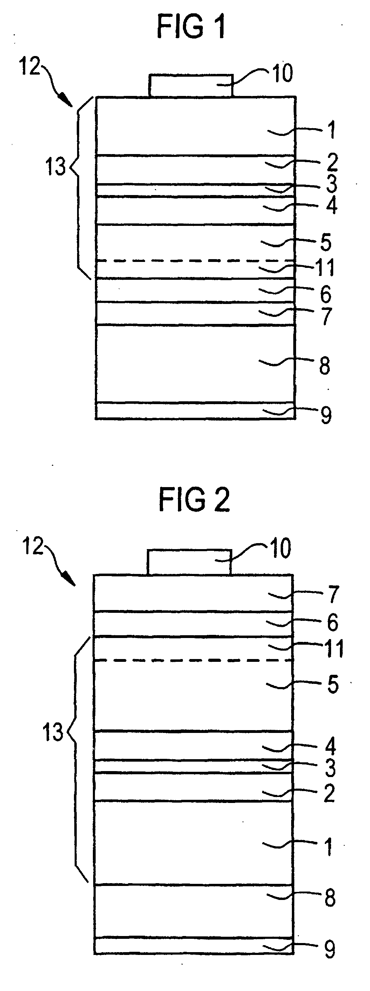

Bei der in Figur 1 gezeigten Schichtstruktur handelt es sich um den Halbleiterkörper 12 eines SCH-Quantentopf-Halbleiterlasers. Auf einem Halbleitersubstrat 8 eines ersten Leitungstyps, z.B. bestehend aus n-leitendem GaAs, ist eine Folge aus zwei entgegengesetzt leitfähigen, hochdotierten, entarteten Übergangsschichten 6,7 aufgebracht, z. B. auf dem n-leitenden Halbleitersubstrat 8 eine n⁺-leitenden Übergangsschicht 7 und darauf eine p⁺-leitende Übergangsschicht 6. Diese Folge aus Übergangsschichten 6,7 dient als Puffer zwischen einer über den Übergangsschichten 6,7 angeordneten SCH-Quantentopf-Struktur 13. Diese ist beispielsweise aus Deckschichten, wie einer ersten äußeren Mantelschicht 5 und einer zweiten äußeren Mantelschicht 1 und einer ersten Wellenleiterschicht 4 und einer zweiten Wellenleiterschicht 2, und einer aktiven Zone 3 gebildet.

Hierbei sind das Halbleitersubstrat 8 und die Übergangsschicht 7 von einem ersten Leitungstyp (z. B. Löcher- oder Elektronenleitung) und die Übergangsschicht 6 und die erste Mantelschicht 5 von einem dem ersten Leitungstyp entgegengesetzten zweiten Leitungstyp. Der Leitungstyp der zweiten Mantelschicht 1 ist ebenfalls entgegengesetzt zu dem der ersten Mantelschicht 5.

Die Übergangsschicht 7 besteht beispielsweise aus hochdotiertem, n-leitendem InₓCa₁₋ₓAs oder aus hochdotiertem, n-leitendem BeₓMg_{y}Zn_{1-x-y}Se (0 <=x<=1, 0<=y<=1, x+y<=l) und die Übergangsschicht 6 besteht beispielsweise aus hochdotiertem, p-leitendem BeₓMg_{y}Zn_{1-x-y}Te (0<=x<=1, x+y<=1).

Die SCH-Quantentopf-Struktur 13 weist beispielsweise einen BeₓZn_{y}Cd_{1-x-y}Se-Quantentopf (0<=x<=1, x+y<=1) als aktive Zone 3, BeₓMg_{y}Zn_{1-x-y}Se-Schichten (0<=x<=1, 0<=y<1, x+y<=1) als Wellenleiterschichten 4,2 und BeₓMg_{y}Zn_{1-x-y}Se-Schichten (0<=x<=1, 0<=y<=1, x+y<=1) als Mantelschichten 1,5 auf, wobei sich die erste Mantelschicht 5 z. B. aus einer Anpassungsschicht 11, bestehend aus einem BeZnTeSe-Grading oder einem BeTe/ZnSe-Pseudograding, und einer p-dotierten BeₓMg_{y}Zn_{1-x-y}Se-Schicht (0<=x<=1, 0<=y<=1, x+y<=1) zusammensetzt. Die Anpassungsschicht 11 kann aber auch weggelassen sein, so daß die erste äußere Mantelschicht 5 direkt auf der zweiten Übergangsschicht 6 aufgebracht ist. Die zweite Mantelschicht 1 kann beispielsweise n-leitendes BeₓMg_{y}Zn_{1-x-y}Se (0<=x<=1, 0<=y<=1, x+y<=1) aufweisen.

Den elektrischen Anschluss des Halbleiterkörpers 12 bilden ein ohmscher Rückseitenkontakt 9 und ein ohmscher Vorderseitenkontakt 10, wobei der ohmsche Rückseitenkontakt 9 an der Unterseite des Halbleitersubstrats 8 und der ohmsche Vorderseitenkontakt 10 auf der zweiten äußeren Mantelschicht 1 angeordnet ist. Im Falle eines n-leitenden GaAs-Substrat 8 können auf einfache Weise herstellbare herkömmliche n-Oberseitenkontakte verwendet sein. Der zweite ohmsche Kontakt 10 kann zum Beispiel aus einer Folge von Ti/Pt/Au oder aus Aluminium bestehen.

Bei dem Ausführungsbeispiel gemäß Figur 2 ist im Unterschied zu dem oben beschriebenen Ausführungsbeispiel gemäß Figur 1 die Folge der hochdotierten entarteten Übergangsschichten 6 und 7 zwischen dem Vorderseitenkontakt 10 und der SCH-Quantentopf-Struktur 13 angeordnet. Der Vorderseitenkontakt 10 ist demzufolge nicht mehr auf der zweiten Mantelschicht 1 sondern auf der Übergangsschicht 7 oder auf einer über dieser angeordneten weiteren Schicht aufgebracht. Die SCH-Quantentopf-Struktur 13 und die Folge der hochdotierten entarteten Übergangsschichten 6,7 ist insgesamt in umgekehrter Reihenfolge wie beim Ausführungsbeispiel gemäß Figur 1 auf dem Halbleitersubstrat 8 aufgebracht. Die einzelnen Schichten bestehen beispielsweise aus denselben Materialien wie die entsprechenden Schichten des Ausführungsbeispiels gemäß Figur 1.

Das Halbleitersubstrat besteht demgemäß beispielsweise wiederum aus n-leitendem GaAs, auf dem eine SCH-Quantentopf-Struktur 13 aufgebracht ist, die beispielsweise einen BeₓZn_{y}Cd_{1-x-y}Se-Quantentopf (0<=x<=1, x+y<=1) als aktive Zone 3, BeₓMg_{y}Zn_{1-x-y}Se-Schichten (0<=x<=1, 0<=y<1, x+y<=1) als Wellenleiterschichten 4,2 und BeₓMg_{y}Zn_{1-x-y}Se-Schichten (0<=x<=1, 0<=y<=1, x+y<=1) als Mantelschichten 1,5 aufweist, wobei sich die erste Mantelschicht 5 z. B. aus einer Anpassungsschicht, bestehend aus einem BeZnTeSe-Grading oder einem BeTe/ZnSe-Pseudograding, und einer p-dotierten BeₓMg_{y}Zn_{1-x-y}Se-Schicht (0<=x<=1, 0<=y<=1, x+y<=1) zusammensetzt. Auch hier kann aber die Anpassungsschicht 11 weggelassen sein, so daß die erste äußere Mantelschicht 5 direkt an die zweite Übergangsschicht 6 angrenzt.

Auf der dem GaAs-Substrat 8 gegenüberliegenden Seite der SCH-Quantentopf-Struktur 13 ist beispielsweise eine hochdotierte, p-leitende Übergangsschicht 6, bestehend aus BeₓMg_{y}Zn_{1-x-y}Te (0<=x<=1, x+y<=1) angeordnet, auf der wiederum eine hochdotierte, n-leitende Übergangsschicht 7, beispielsweise bestehend aus BeₓMg_{y}Zn_{1-x-y}Se (0<=x<=1, 0<=y<=1, x+y<=1) angeordnet ist. Die Verwendung dieser hochdotierten n-leitenden Übergangsschicht 7 verhindert vorteilhafterweise den unmittelbaren Kontakt von BeTe mit Luft, wodurch technologisch deutliche Vorteile gewonnen werden und niederohmige Kontakte erzeugt werden können. Der Vorderseitenkontakt 10 kann zum Beispiel aus einer Folge von Ti/Pt/Au oder Aluminium bestehen.

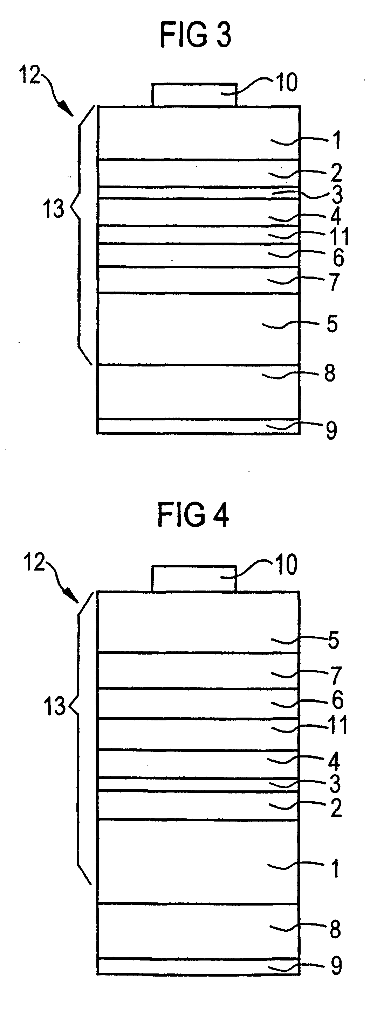

Bei dem Ausführungsbeispiel gemäß Figur 3 ist die Folge der hochdotierten entarteten Übergangsschichten 6 und 7 zwischen der ersten äußeren Mantelschicht 5 und der ersten Wellenleiterschicht 4 angeordnet. Die Reihenfolge der einzelnen Schichten ausgehend vom Halbleitersubstrat 8 eines ersten Leitungstyps lautet bei diesem Ausführungsbeispiel wie folgt:
erste äußere Mantelschicht 5 vom ersten Leitungstyp,
erste entartete Übergangsschicht 7 vom ersten Leitungstyp,
zweite entartete Übergangsschicht 6 vom zweiten Leitungstyp,
erste Wellenleiterschicht 4,
aktive Zone 3,
zweite Wellenleiterschicht 2,
zweite äußere Mantelschicht 1 vom ersten Leitungstyp und Vorderseitenkontakt 10.
Die einzelnen Schichten bestehen beispielsweise aus denselben Materialien wie die entsprechenden Schichten des Ausführungsbeispiels gemäß Figur 1.

Darüber hinaus kann es notwendig sein, zwischen der hochdotierten zweiten entarteten Übergangsschicht 6 und der ersten Wellenleiterschicht 4 eine Anpassungsschicht 11 einzufügen, mit welcher der Transport von Ladungsträgern in den Quantentopf 3 ermöglicht wird. Dabei ist darauf zu achten, dass diese Schicht für Ladungsträger einer Sorte eine Barriere bildet. Gleichzeitig wird für den komplementären Ladungsträgertyp der Transport ermöglicht.

Die Brechungsindizes der ersten entarteten Übergangsschicht 7, der zweiten entarteten Übergangsschicht 6 und der Anpassungsschicht 11 sind vorteilhafterweise der Funktion als Wellenleiter angepasst. Insbesondere ist darauf zu achten, dass die Brechungsindizes der äußeren Mantelschichten 1 und 5 kleiner als in den übrigen Schichten (zweite Wellenleiterschicht 2, aktive Zone 3, erste Wellenleiterschicht 4, zweite entartete Übergangsschicht 6, erste entartete Übergangsschicht 7, Anpassungsschicht 11) sind. In dieser Ausführungsförm sind wiederum die Schichten 1, 2, 5, 7, 8 vom gleichen Leitungstyp. In den Schichten 4, 6, 11 dominiert der diesem entgegengesetzte Leitungstyp.

In einer speziellen Ausführungsform dieses Ausführungsbeispieles ist das Halbleitersubstrat 8 ein n-leitendes GaAs-Substrat, auf dem eine n-leitende BeₓMg_{y}Zn_{1-x-y}Se (0<=x<=1, 0<=y<=1, x+y<=1)-Schicht als erste äußere Mantelschicht 5 aufgebracht ist.

Die Übergangsschicht 7 ist beispielsweise eine hoch n-leitende BeₓMg_{y}Zn_{1-x-y}Se-Schicht (0<=x<=1, 0<=y<=1, x+y<=1) und die Übergangsschicht 6 ist beispielsweise eine hoch p-leitendende BeₓMg_{y}Zn_{1-x-y}Te-Schicht (0<=x<=1, x+y<=1), die mittels einem p-leitenden BeZnTeSe-Grading oder mittels einem Be-Te/ZnSe-Pseudograding als Anpassungsschicht 11 elektrisch an die Wellenleiterschicht 4 angeschlossen ist. Die aktive Zone 3 weist einen Quantentopf aus z. B. BeₓZn_{y}Cd_{1-x-y}Se (0<=x<=1, 0<=y<=1, x+y<=1) auf. Die Wellenleiterschichten 2, 4 können aus BeₓMg_{y}Zn_{1-x-y}Se (0<=x<=1, 0<=y<=1, x+y<=1) bestehen. Die zweite äußere Mantelschicht 1 besteht beispielsweise aus n-leitendem BeₓMg_{y}Zn_{1-x-y}Se (0<=x<=1, 0<=y<=1, x+y<=1) und der Kontakt 10 besteht zum Beispiel aus einer Folge von Ti/Pt/Au oder aus Aluminium.

Die Summe der Schichtdicken der Schichten 2, 3, 4, 6, 7, 11, also der Schichten, die als Wellenleiter wirken, soll vorteilhafterweise 100 nm nicht unterschreiten und 400 nm nicht überschreiten, wohingegen die Mantelschichten 1 und 5 mindestens 200 nm dick sein sollen. Mit diesem Aufbau können hohe Konzentrationen von Be und Mg in BeMgZnSe oder Mg und S in ZnMgSSe in den Deckschichten 1 bzw. 5 erzielt werden, da die n-Dotierung dieser Materialien erfahrungsgemäß effizienter als die p-Dotierung ist. Auf diese Weise können Bandlücken in den Deckschichten von über 3,1 eV (300K) erreicht werden. Mit diesen hohen Konzentrationen ist es möglich, den elektrischen Ladungsträgereinschluss zu verbessern und die optische Welle besser zu führen. Darüber hinaus entfallen hochohmige Bereiche aus p-dotiertem BeMgZnSe oder ZnMgSSe. Ein weiterer Vorteil ergibt sich bei der Verwendung von BeₓMg_{y}Zn_{1-x-y}Te in Bauelementen, die kurzwelliges Licht mit Wellenlängen kleiner als 460nm emittieren. Für diese Wellenlänge hat BeₓMg_{y}Zn_{1-x-y}Te einen kleineren Brechungsindex als zum Beispiel BeₓZn_{y}Cd₁₋ₓ₋ _{y}Se, wodurch die optische Welle unter Verwendung von BeₓMg_{y}Zn_{1-x-y}Te in Schicht 6 und 11 noch besser geführt wird.

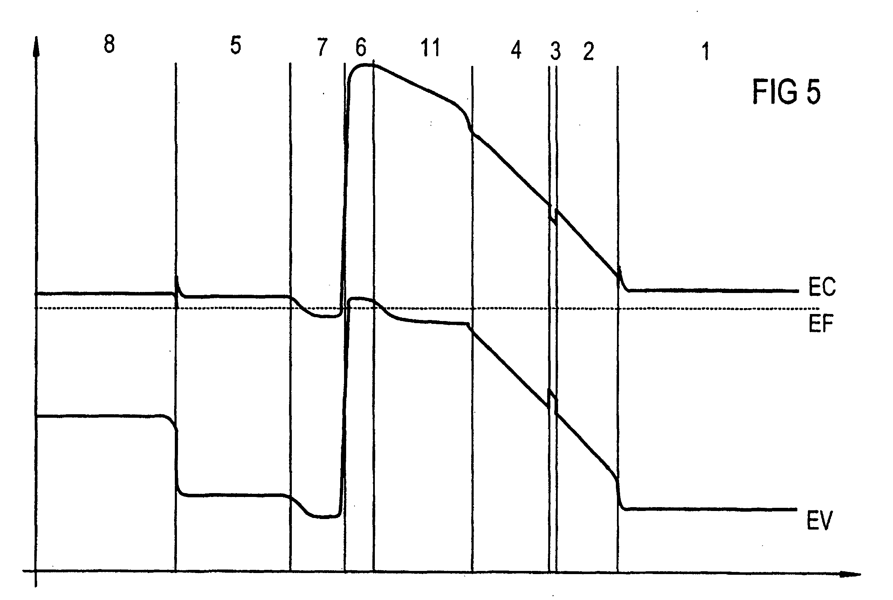

Das Bänderschema des Ausführungsbeispiels des erfindungsgemäßen Bauelements nach Figur 3 ist in Figur 5 schematisch dargestellt. Die einzelnen Bereiche sind analog zu der Schichtenfolge von Figur 3 bezeichnet. Die Ladungsträgerinjektion in diesem Schichtaufbau geschieht wie folgt : Durch Anlegen einer elektrischen Spannung, die den pn-Übergang, dessen p-Seite aus den Schichten 6, 11 und 4 und dessen n-Seite aus den Schichten 2 und 1 besteht, in Durchlassrichtung vorspannt, werden Elektronen vom Kontakt 10 (in Figur 5 nicht gezeichnet) über die Mantelschicht 1 und die Wellenleiterschicht 2 in die aktive Zone 3 gebracht. Die Anpassungsschicht 11 verhindert hierbei durch eine Energiebarriere, dass negative Ladungsträger in die hoch p-dotierte Übergangsschicht 6 abwandern können (diese Funktion kann alternativ auch von Schicht 4 übernommen werden). Von der Substratseite der SCH-Quantentopf-Struktur 13 werden in diesem Beispiel über die hoch n-dotierte Übergangsschicht 7, die n-leitende äußere Mantelschicht 5 und das n-GaAs-Substrat 8 Elektronen durch das Anlegen der äußeren Spannung herausgezogen. Am Übergang zwischen der hoch n-dotierten Übergangsschicht 7 und der hoch p-dotierten Übergangsschicht 6 können Elektronen aus dem Valenzband vom Material der p-dotierten Übergangsschicht 6 die Barriere zum Leitungsband von Übergangsschicht 7 durchdringen, wodurch ein effektiver Löcherstrom über die Schichten 6, 11 und 4 in die aktive Zone 3 entsteht. Hierbei bilden die Wellenleiterschicht 2 oder/und die äußere Mantelschicht 1 eine Energiebarriere für Löcher.

Bei dem Ausführungsbeispiel von Figur 4 ist im Unterschied zum Ausführungsbeispiel gemäß Figur 3 der Aufbau der SCH-Quantentopf-Struktur 13 nach Figur 3 in umgekehrter Reihenfolge auf dem Halbleitersubstrat 8 aufgebracht. Die Löcherinjektion findet jetzt über die auf der oberflächennahen Seite der aktiven Zone 3 liegende Folge der Übergangsschichten 6 und 7 statt, die wiederum entgegengesetzt dotiert und hoch leitfähig ist. Ansonsten ist der Aufbau und die Materialwahl für die entsprechenden Schichten analog dem Ausführungsbeispiel von Figur 3.

Unter hoch n-dotiert (oder n⁺-dotiert) und hoch p-dotiert (oder p⁺-dotiert), also entarteter Dotierung, ist jeweils vorteilhafterweise eine Dotierstoff-Konzentration von ≥ 10¹⁷ cm⁻³ zu verstehen.

Die Beschreibung des erfindungsgemäßen Halbleiterbauelements anhand dieser Ausführungsbeispiele ist selbstverständlich nicht als Beschränkung der Erfingung auf diese Ausführungsbeispiele zu verstehen. Erfindungsgemäße Leuchtdioden und Laserdioden können ebenso auf der Basis anderer Halbleitermaterialien ausgebildet sein, wie zum Beispiel GaN oder verwandte Mischkristallsysteme, oder II-IV-Halbleiter, wie CdTe, BeTe, BeSe, ZnS, MgS, CdSe, HgTe oder verwandte Mischkristallsysteme, wie ZnₓCd₁₋ₓS_{y}Se_{1-y},
BeₓZn_{y}Cd_{1-x-y}Te, BeₓMg_{y}Zn_{1-x-y}Te, BeₓMg_{y}Zn_{1-x-y}S oder BeₓZn_{y}Cd_{1-x-y}S. Als Subtrat können neben GaAs z. B. GaP, ZnSe, Si, Ge, InP, InGaAs, ZnO, Al₂O₃ ,SiC oder ähnliches verwendet sein.

## Patentansprüche

1. Optoelektronisches Halbleiterbauelement mit einem zur Erzeugung einer elektromagnetischen Strahlung geeigneten Halbleiterkörper (12), bei dem über einem Halbleitersubstrat (8) eine aktive Zone (3) angeordnet ist, innerhalb der bei Stromfluss durch den Halbleiterkörper (12) die elektromagnetische Strahlung erzeugt wird und der mindestens eine p-dotierte ZnSe aufweisende II-VI-Halbleiterschicht zugeordnet ist, wobei als elektrische Ladungsträgerquelle zwischen der schlecht dotierbaren ZnSe aufweisenden. Halbleiterschnicht und einer dieser zugeordneten Kontaktschicht (9) des Halbleiterkörpers eine rückwärtsgepolte Schichtenfolge mit einer ersten hochdotierten entarteten Übergangsschicht (6) des ersten Leitungstyps und einer zweiten hochdotierten entarteten Übergangsschicht (7) eines dem ersten Leitungstyps entgegengesetzten zweiten Leitungstyps angeordnet ist, wobei sich die erste hochdotierte entartete Übergangsschicht (6) zwischen der schlecht dotierbaren Halbleiterschicht und der zweiten hochdotierten entarteten Übergangsschicht (7) befindet und die erste hochdotierte entartete Übergangsschicht (6) eine p⁺-leitende Übergangsschicht ist, **dadurch gekennzeichnet, dass** die erste hoch dotierte entartete Übergangsschicht (6) BeTe enthält.

2. Optoelektronisches Halbleiterbauelement nach Anspruch 1,
**dadurch gekennzeichnet, dass**
die p-dotierte ZnSe aufweisende Schicht eine ZnMgSSe oder eine BeMgZnSe aufweisende II-VI-Halbleiterschicht enthält.

3. Optoelektronisches Halbleiterbauelement nach Anspruch 1 oder 2,
**dadurch gekennzeichnet, dass**
die p⁺-leitende Übergangsschicht BeMgZnTe oder BeZnCdTe aufweist.

4. Optoelektronisches Halbleiterbauelement nach einem der Ansprüche 1 bis 3,
**dadurch gekennzeichnet, dass**
die aktive Zone (3) eine zwischen einer ersten Wellenleiterschicht (4) und einer zweiten Wellenleiterschicht (2) angeordnete Quantentopfstruktur aufweist.

5. Optoelektronisches Halbleiterbauelement nach Anspruch 4,
**dadurch gekennzeichnet, dass**
die aktive Zone (3) und die erste und die zweite Wellenleiterschicht (2,4) zwischen einer ersten äußeren Mantelschicht (5) und einer zweiten äußeren Mantelschicht (1) angeordnet sind.

6. Optoelektronisches Halbleiterbauelement nach Anspruch 5,
**dadurch gekennzeichnet, dass**
die zweite äußere Mantelschicht (1) vom zweiten Leitungstyp ist und die erste äußere Mantelschicht (5) die schlecht dotierbare Halbleiterschicht aufweist und dass die erste hochdotierte entartete Übergangsschicht (6) und die zweite hochdotierte entartete Übergangsschicht (7) zwischen der zweiten äußeren Mantelschicht (5) und der dieser zugeordneten Kontaktschicht (9) des Halbleiterkörpers (12) angeordnet sind.

7. Optoelektronisches Halbleiterbauelement nach Anspruch 5,
**dadurch gekennzeichnet, dass**
die erste äußere Mantelschicht (5) und die zweite äußere Mantelschicht (1) vom zweiten Leitungstyp sind, und dass zwischen einer der beiden Wellenleiterschichten (2,4) und der dieser von der aktiven Zone (3) gesehen nachgeordneten äußeren Mantelschicht (1,5) die schlecht dotierbare Halbleiterschicht (11), die erste hochdotierte entartete Übergangsschicht (6) und die zweite hochdotierte entartete Übergargsschicht (7) angeordnet sind.

8. Optoelektronisches Halbleiterbauelement nach Anspruch 5,
**dadurch gekennzeichnet, dass**
die erste äußere Mantelschicht (5) und die zweite äußere Mantelschicht (1) vom zweiten Leitungstyp sind, dass auf einer der beiden Wellenleiterschichten (2,4) die erste hochdotierte entartete Übergangsschicht (6) und auf dieser die zweite hochdotierte entartete Übergangsschicht (7) aufgebracht ist und dass dieser eine der äußeren Mantelschichten (1,5) von der aktiven Zone (3) aus gesehen nachgeordnet ist.

9. Optoelektronisches Halbleiterbauelement nach einem der Ansprüche 1 bis 8,
**dadurch gekennzeichnet, dass**
die aktive Zone (3) Halbleitermaterial aus der Gruppe der berylliumhaltigen Chalkogenide oder Zn₁₋ₓCdₓS_{y}Se_{1-y} aufweist.

10. Optoelektronisches Halbleiterbauelement nach einem der Ansprüche 4 bis 8 oder nach einem der Ansprüche 4 bis 8 und Anspruch 9,
**dadurch gekennzeichnet, dass**
die erste Wellenleiterschicht (4) und die zweite Wellenleiterschicht (2) Halbleitermaterial aus der Gruppe der berylliumhaltigen Chalkogenide aufweisen.

11. Optoelektronisches Halbleiterbauelement nach einem der Ansprüche 5 bis 8 oder nach einem der Ansprüche 5 bis 8 und Anspruch 9 oder 10,
**dadurch gekennzeichnet, dass**
die erste äußere Mantelschicht (5) und die zweite äußere Mantelschicht (1) Halbleitermaterial aus der Gruppe der berylliumhaltigen Chalkogenide aufweisen.

12. Optoelektronisches Halbleiterbauelement nach einem der Ansprüche 1 bis 11,
**dadurch gekennzeichnet, dass**
die p⁺-leitende Übergangsschicht (6) mit einem Dotierstoff aus der Gruppe As, Sb, P, K, Rb, Cs, C, Si, Ge und Sn dotiert ist.

13. Optoelektronisches Halbleiterbauelement nach einem der Ansprüche 5 bis 8 oder nach einem der Ansprüche 5 bis 8 und einem der Ansprüche 9 bis 12,
**dadurch gekennzeichnet, dass**
der Abstand zwischen den beiden Mantelschichten (1,4) zwischen etwa 100 nm und etwa 400 nm beträgt und dass die erste Mantelschicht (5) und die zweite Mantelschicht (1) jeweils eine Dicke von mindestens 200 nm aufweisen.

## Claims

1. Optoelectronic semiconductor component having a semiconductor body (12) which is suitable for generating electromagnetic radiation, in which an active zone (3) is arranged above a semiconductor substrate (8), within which active zone the electromagnetic radiation is generated when current flows through the semiconductor body (12) and which active zone is assigned at least one p-doped II-VI semiconductor layer having ZnSe, it being the case that a reverse-biased layer sequence having a first heavily doped degenerate junction layer (6) of the first conduction type and a second heavily doped degenerate junction layer (7) of a second conduction type opposite to the first conduction type is arranged as an electrical charge carrier source between the poorly dopable semiconductor layer having ZnSe and a contact layer (9) of the semiconductor body, said contact layer being assigned to said semiconductor layer, where the first heavily doped degenerate junction layer (6) is situated between the poorly dopable semiconductor layer and the second heavily doped degenerate junction layer (7), and **characterized in that** the first heavily doped degenerate junction layer (6) is a p⁺-conducting junction layer and contains BeTe.

2. Optoelctronic semiconductor component according to Claim 1,
**characterized in that**
the p-doped layer having ZnSe contains a II-VI semiconductor layer having ZnMgSSe or a II-VI semiconductor layer having BeMgZnSe.

3. Optoelctronic semiconductor component according to Claim 1 or 2,
**characterized in that**
the p⁺-conducting junction layer has BeMgZnTe or BeZnCdTe.

4. Optoelctronic semiconductor component according to one of Claims 1 to 3,
**characterized in that**
the active zone (3) has a quantum well structure arranged between a first waveguide layer (4) and a second waveguide layer (2).

5. Optoelctronic semiconductor component according to Claim 4,
**characterized in that**
the active zone (3) and the first and second waveguide layers (2, 4) are arranged between a first outer cladding layer (5) and a second outer cladding layer (1).

6. Optoelctronic semiconductor component according to Claim 5,
**characterized in that**
the second outer cladding layer (1) is of the second conducting type and the first outer cladding layer (5) has the poorly dopable semiconductor layer, and **in that** the first heavily doped degenerate junction layer (6) and the second heavily doped degenerate junction layer (7) are arranged between the second outer cladding layer (5) and the contact layer (9) of the semiconductor body (12), said contact layer being assigned to said cladding layer.

7. Optoelctronic semiconductor component according to Claim 5,
**characterized in that**
the first outer cladding layer (5) and the second outer cladding layer (1) are of the second conduction type, and **in that** the poorly dopable semiconductor layer (11), the first heavily doped degenerate junction layer (6) and the second heavily doped degenerate junction layer (7) are arranged between one of the two waveguide layers (2, 4) and the outer cladding layer (1, 5) which is arranged downstream thereof as seen from the active zone (3).

8. Optoelctronic semiconductor component according to Claim 5,
**characterized in that**
the first outer cladding layer (5) and the second outer cladding layer (1) are of the second conduction type, **in that** the first heavily doped degenerate junction layer (6) is applied on one of the two waveguide layers (2, 4) and the second heavily doped degenerate junction layer (7) is applied on said first heavily doped degenerate junction layer, and **in that** one of the outer cladding layers (1, 5) is arranged downstream of said second heavily doped degenerate junction layer, as seen from the active zone (3).

9. Optoelctronic semiconductor component according to one of Claims 1 to 8,
**characterized in that** the active zone (3) has semiconductor material from the group of the beryllium-containing chalcogenides or Zn₁₋ₓCdₓS_{y}Se_{1-y}.

10. Optoelctronic semiconductor component according to one of Claims 4 to 8 or according to one of Claims 4 to 8 and Claim 9,
**characterized in that**
the first waveguide layer (4) and the second waveguide layer (2) have semiconductor material from the group of beryllium-containing chalcogenides.

11. Optoelctronic semiconductor component according to one of Claims 5 to 8 or according to one of Claims 5 to 8 and Claim 9 or 10,
**characterized in that**
the first outer cladding layer (5) and the second outer cladding layer (1) have semiconductor material from the group of beryllium-containing chalcogenides.

12. Optoelctronic semiconductor component according to one of Claims 1 to 11,
**characterized in that**
the p⁺-conducting junction layer (6) is doped with a dopant from the group As, Sb, P, K, Rb, Cs, C, Si, Ge and Sn.

13. Optoelctronic semiconductor component according to one of Claims 5 to 8 or according to one of Claims 5 to 8 and one of Claims 9 to 12,
**characterized in that**
the distance between the two cladding layers (1, 4) is between approximately 100 nm and approximately 400 nm, and **in that** the first cladding layer (5) and the second cladding layer (1) in each case have a thickness of at least 200 nm.

## Revendications

1. Composant à semi-conducteur optoélectronique, ayant un corps semi-conducteur (12) convenant à la production d'un rayonnement électromagnétique, dans lequel il est disposé au-dessus d'un substrat semi-conducteur (8) une zone active (3) au sein de laquelie le rayonnement électromagnétique est produit en présence d'un flux de courant à travers le corps semi-conducteur (12) et à laquelle au moins une couche semi-conductrice II-VI ayant du ZnSe et à dopage p est associée, dans lequel il est disposé comme source électrique de porteurs de charges entre la couche semi-conductrice ayant du ZnSe difficile à doper et une couche de contact (9), associée à celle-ci, du corps semi-conducteur une succession de couches polarisée en sens inverse et comportant une première couche de transition fortement dopée et dégénérée (6) du premier type de conduction et une deuxième couche de transition fortement dopée et )dégénérée (7) d'un deuxième type de conduction opposé au premier type de conduction, dans lequel la première couche de transition fortement dopée et dégénérée (6) se trouva entre la couche semi-conductrice difficile à doper et la deuxième couche de transition fortement dopée et dégénérée (7) et dans lequel la première couche de transition fortement dopée et dégénérée (6) est une couche de transition à conduction p⁺,
**caractérisé par le fait que** la première couche de transition fortement dopée et dégénérée (6) contient du BeTe.

2. Composant à semi-conducteur optoélectronique selon la revendication 1,
**caractérisé par le fait que** la couche comportant du ZnSe et à dopage p contient une couche semi-conductrice II-VI comportant du ZnMgSSe ou du BeMgZnSe.

3. Composant à semi-conducteur optoélectronique selon la revendication 1 ou 2,
**caractérisé par le fait que** la couche de transition à conduction p⁺ comporte du BeMgZnTe ou du BeZnCdTe.

4. Composant à semi-conducteur optoélectronique selon l'une des revendications 1 à 3,
**caractérisé par le fait que** la zone active (3) comporte une structure à puits quantique disposée entre une première couche guide d'ondes (4) et une deuxième couche guide d'ondes (2).

5. Composant à semi-conducteur optoélectronique selon la revendication 4,
**caractérisé par le fait que** la zone active (3) ainsi que la première et la deuxième couche guide d'ondes (2, 4) sont disposées entre une première couche protectrice externe (5) et une deuxième couche protectrice exteme (1).

6. Composant à semi-conducteur optoélectronique selon la revendication 5,
**caractérisé par le fait que** la deuxième couche protectrice externe (1) est du deuxième type de conduction, que la première couche protectrice externe (5) comporte la couche semi-conductrice difficile à doper et que la première couche de transition fortement dopée et dégénérée (6) et la deuxième couche de transition fortement dopée et dégénérée (7) sont disposées entre la deuxième couche protectrice externe (5) et la couche de contact (9), associée à celle-ci, du corps semi-conducteur (12).

7. Composant à semi-conducteur optoélectronique selon la revendication 5,
**caractérisé par le fait que** la première couche protectrice externe (5) et la deuxième couche protectrice externe (1) sont du deuxième type de conduction et qu'il est disposé entre l'une des deux couches guides d'ondes (2, 4) et la couche protectrice externe (1, 5) placée après celle-ci vu de la zone active (3) la couche semi-conductrice difficile à doper (11), la première couche de transition fortement dopée et dégénérée (6) et la deuxième couche de transition fortement dopée et dégénérée (7).

8. Composant à semi-conducteur optoélectronique selon la revendication 5,
**caractérisé par le fait que** la première couche protectrice externe (5) et la deuxième couche protectrice externe (1) sont du deuxième type de conduction, que la première couche de transition fortement dopée et dégénérée (6) est appliquée sur l'une des deux couches guides d'ondes (2, 4), que la deuxième couche de transition fortement dopée et dégénérée (7) est appliquée sur cette première couche de transition et que rune des couches protectrices externes (1, 5) est placée après cette deuxième couche de transition vu de la zone active (3).

9. Composant à semi-conducteur optoélectronique selon l'une des revendications 1 à 8,
**caractérisé par le fait que** la zone active (3) comporte du matériau semi-conducteur du groupe des chalcogénures contenant du béryllium ou Zn₁₋ₓCdₓS_{y}Se_{1-y}.

10. Composant à semi-conducteur optoélectronique selon l'une des revendications 4 à 8 ou selon l'une des revendications 4 à 8 et la revendication 9,
**caractérisé par le fait que** la première couche guide d'ondes (4) et la deuxième couche guide d'ondes (2) comportent du matériau semi-conducteur du groups des chalcogénures contenant du béryllium.

11. Composant à semi-conducteur optoéiectronique selon l'une des revendications 5 à 8 ou selon l'une des revendications 5 à 8 et la revendication 9 ou 10,
**caractérisé par le fait que** la première couche protectrice externe (5) et la deuxième couche protectrice exteme (1) comportent du matériau semi-conducteur du groupe des chalcogénures contenant du béryllium.

12. Composant à semi-conducteur optoélectronique selon l'une des revendications 1 à 11,
**caractérisé par le fait que** la couche de transition à conduction p⁺ (6) est dopée avec un agent de dopage du groupe As, Sb, P, K, Rb, Cs, C, Si, Ge et Sn.

13. Composant à semi-conducteur optoélectronique selon l'une des revendications 5 à 8 ou selon l'une des revendications 5 à 8 et l'une des revendications 9 à 12,
**caractérisé par le fait que** la distance entre les deux couches protectrices (1, 4) est comprise entre 100 nm environ et 400 nm environ et que la première couche protectrice (5) et la deuxième couche protectrice (1) ont chacune une épaisseur d'au moins 200 nm.
